# EUROPEAN PATENT SPECIFICATION

(11) **EP 1 679 629 B1**
(45) Date of publication and mention of the grant of the patent: **04.07.2012**
(21) Application number: 05380225.2
(22) Date of filing: 13.10.2005
(51) Int. Cl.: G06F 17/50, F16J 15/00

(54) **Process for simulating the positioning of sealing gaskets by means of finite elements calculation**
Verfahren zur Simulation der Platzierung einer Dichtung mit Hilfe einer Finite-Element-Berechnung
Procédé de simulation de placement d'un joint à l'aide d'un calcul d'éléments finis

(30) Priority: 29.12.2004 ES 200403128
(43) Date of publication of application: 12.07.2006
(73) Proprietor: Seat, S.A., 08040 Barcelona (ES)
(72) Inventor: Carreras Vilalta, Josep, 08760 Martorell (Barcelona) (ES); Guerra Higuero, Josep Lluis, 08760 Martorell (Barcelona) (ES); Viaplana Canal, Arnau, 08760 Martorell (Barcelona) (ES)
(74) Representative: Carvajal y Urquijo, Isabel

(56) References cited:
- EP-A1- 1 158 846
- WO-A1-01/48699
- WO-A2-00/52772

## Description

### Field of the Invention

The present invention is within the field of simulation of sealing gaskets in mobile parts of a vehicle by means of finite elements calculation. The object is to obtain the shape adopted by the sealing gasket once assembled on the flange, with its folds, creases, etc.

### Background of the Invention

Simulations by means of finite element analysis are currently carried out for the mobile parts of a vehicle, with the object of performing calculations for profile rigidity, closing forces, clearance studies, etc.

One of the subjects of study is gasket straining on the corners and curves of the sealing profile. At this point the problem consist in simulating the position of the sheath forming the gasket along the sealing flange with the object of observing its straining in the maximum curvature areas.

This positioning simulation process is currently carried out in a virtually manual manner, the calculation preparation stage being very time-consuming. In fact, the calculation is prepared by placing the gasket directly above the flange. It is a very time-consuming process because the set of displacements necessary for positioning the gasket has to be manually calculated, being further limited to very simple curves.

Furthermore, another drawback occurs: the first solution found being the definitive one, this implies that the difference with the initial positions may be very large; consequently, the calculation takes a long time to converge in a solution (in the range of 3 to 4 days for a 200 mm profile). On the other hand, the intermediate solutions are not significant, because they do not represent a situation which is possible in reality.

That is, the current process has the following drawbacks:
- preparation for the calculation is very costly,
- convergence of the calculation is difficult and requires a long calculation time,
- its application is only possible for maximum lengths of 200 mm and for very simple curve geometries.

WO 00/52772 A2 (EVEREADY BATTERY INC [US]) 8 September 2000 (2000-09-08) for example discloses the use of finite element modelling of the case of gaskets.

### Description of the Invention

The invention refers to a simulation process for simulating the positioning of gaskets according to claim 1. Preferred embodiments of the process are defined in the dependant claims.

The positioning process of the present invention allows notably accelerating the calculation preparation stage, and a correct simulation of the sheath positioning is almost automatically obtained in a completely parameterised manner.

This new process allows the possibility of simulating the positioning of gaskets of much longer lengths on the flange geometry, in order to thus calculate their final position, the closing forces of the mobile parts, etc. in an automatic and much more precise manner.

This is achieved by means of a positioning process carried out by the incremental insertion of the gasket, determined by the geometry of the curves describing the flange. That is, it is a progressive introduction of the gasket in the flange.

According to an aspect of the present invention, this refers to a position simulation process of a sealing gasket on a flange, where
- said flange has a geometry defined by two curves; and
- said gasket is defined by a 3D finite element model;
characterised in that the process comprises the following stages:
- determining a first set {P₀, P₁, ..., Pₚ} of pairs of points on said two curves defining the geometry of the flange;
- determining a set {N₀, N₁, ..., Nₙ} of pairs of nodes of the 3D finite element model defining the sealing gasket with n ≤ p;
- initially positioning the pair of nodes N₀ on the pair of points P₀;
- performing j iterations, with j ≤ n, where j displacements are applied simultaneously in each iteration j in order to position the pair of nodes N₀ on the pair of points Pⱼ, the pair of nodes N₁ on the pair of points Pⱼ₋₁, ...., the pair of nodes Nⱼ on the pair of points P₀, and n - j displacements to position all the remaining pairs of nodes Nᵢ on the position of the pair of nodes Nᵢ₋₁, for i > j.

Preferably the step of determining a first set {P₀, P₁, ..., Pₚ} of pairs of points on said two curves defining the geometry of the flange comprises:
- defining an auxiliary curve which is the bisector of said two curves,
- determining p points uniformly distributed on said auxiliary curve,
- orthogonally projecting said p points on said two curves,
said projections forming the set of pairs of points {P₀, P₁, ..., Pₚ}.

Preferably three curves are used in order to define the geometry of the flange, the flange path being uivocally defined.

As valid solutions are obtained for each displacement, the process may be stopped at any time if it is observed that the profile does not behave correctly even before its definitive position.

The increase in calculation speed is the consequence of the proximity between intermediate solutions; as there is very little difference from one displacement to the next, a solution is found very quickly.

The positioning process of the invention thus allows adapting to flanges with complex geometries of any length.

### Brief Description of the Drawings

A series of drawings aiding towards a better understanding of the invention and directly related to an embodiment of said invention, presented as a non-limiting example thereof, is described below very briefly.

Figure 1 shows in a very general manner the positioning process used in the state of the art.

Figure 2 shows in a very general manner the gasket positioning process according to the present invention.

Figure 3 shows the stage of defining the initial geometries of the 2D section of the gasket and the curves defining the flange.

Figure 4 shows the stage corresponding to the extrusion of the gasket profile at the required length.

Figure 5 shows the stage of nomenclature of the points and nodes (initial position) as well as the advancement direction of the gasket.

Figure 6 shows a stage of intermediate calculation of the displacement of the gasket along the flange.

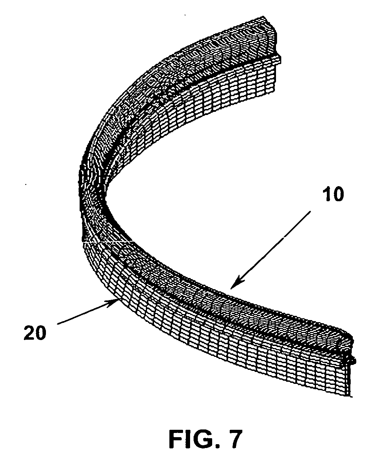

Figure 7 shows the final position of the gasket on the flange.

### Description of a Preferred Embodiment of the Invention

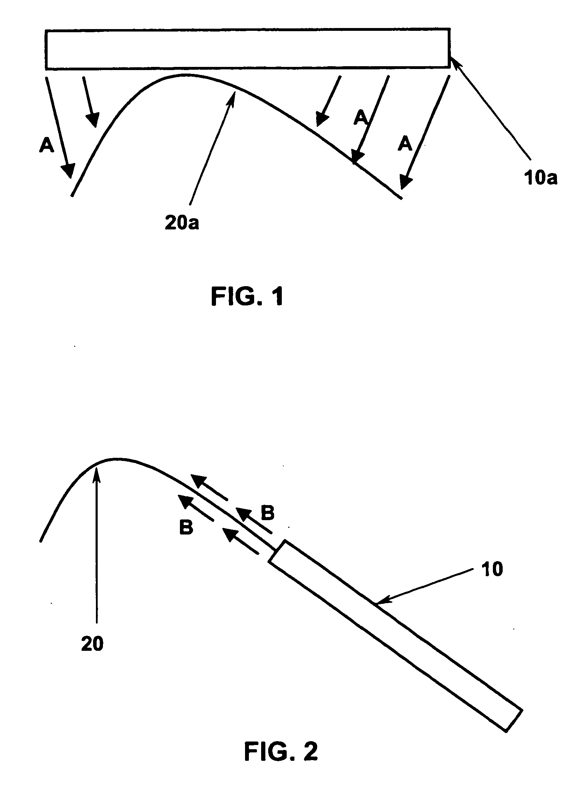

Such as is shown in a general manner in Figure 1, the gasket positioning simulation process is currently performed manually, placing (as indicated by the arrows
A) the gasket 10a directly on the flange 20a.

Figure 2 shows the essence of the positioning process of the invention, in which an incremental and progressive introduction (such as indicated by the arrows B) of the gasket 10 on the flange 20 is carried out.

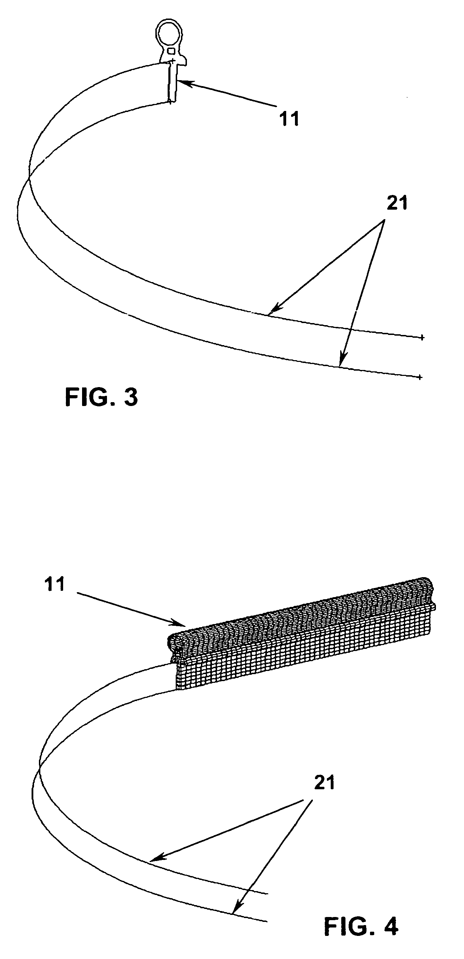

Figure 3 shows in a general manner the geometry definition: on one hand, starting from two curves 21 defining the flange 20 geometry. On the other hand, preparing the section 11 in two 2D dimensions of the gasket 10 to be studied.

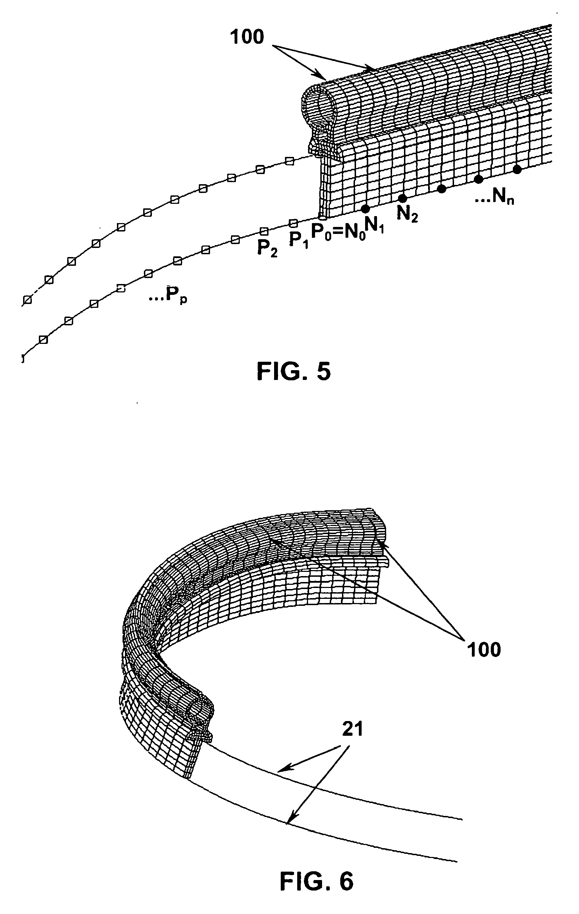

Figure 4 shows the extrusion of the gasket profile at the required length, which must be approximately equal to the length of the gasket to be positioned. Starting from a 2D finite element model of the gasket, determining a series of nodes {N₀, N₁, ..., Nₙ} on which the successive displacements are applied (see Figure 5).

The extrusion process is performed by adding gasket elements 100 of constant section of a certain length k. For example, for a 200 mm gasket 200 elements of *k*=1 mm or 100 elements of *k*=2 mm may be added. This process creates a 3D model of the gasket 10 which is subsequently used for being positioned on the flange 20. The more elements forming the profile of the extruded gasket, the more precise the solution will be, but also the calculation time will be longer. Said solution will be the final shape of the gasket once positioned on the flange.

As shown in Figure 5 (this Figure 5 shows the positioning starting point between the gasket and the flange), p points are selected {P₀, P₁, ..., Pₚ}, uniformly distributed on the curves. The problem is that if the selected points are used on one of the curves in order to determine the equivalent points on the other, an incorrect solution is generated, since it is not assured that in this second curve the points thus generated are uniformly distributed.

In order to solve this problem, an auxiliary curve which is the bisector of the two curves is generated, and points {P₀, P₁, ..., Pₚ} are calculated which are uniformly distributed upon it. These points are subsequently orthogonally projected on the two generating curves of the flange, such that the projected points will determine the successive stages of the positioning of the gasket.

As shown in a general manner in Figure 6, the profile of the gasket is successively advanced on the flange. Thus:
- initially the pair of nodes N₀ is located on the pair of points P₀,
- iteration 1: displacements are simultaneously applied in order to position the pair of nodes N₀ on the pair of points P_{1,} N₁ on P₀ and all the pairs of nodes Nᵢ on the position of Nᵢ₋₁, for i > 1,
- iteration 2: displacements are simultaneously applied in order to position the pair of nodes N₀ on P₂, N₁ on P₁ and N₂ on P₀ and all the remaining pairs of nodes Nᵢ on the position of Nᵢ₋₁, for i > 2.

In general, in iteration j of the process (j ≤ n), j displacements are applied simultaneously in order to position N₀ on Pⱼ, N₁ on Pⱼ₋₁, ..., Nⱼ on P₀, and n - j displacements to position all the remaining pairs of nodes Nᵢ on the position of Nᵢ₋₁, for i >j.

After performing n iterations of this process, the calculation determines the final shape adopted by the sealing gasket as it is completely positioned on the flange.

That is, initially, one end of the gasket is located on the beginning of the curves describing the flange geometry. In each iteration of the process, a displacement is applied to the gasket in order to place its end on the next pair of points P of the curves. The gasket is thus progressively positioned on an increasing portion of the flange. At the end of the process, the profile of the gasket is completely positioned on the flange.

## Claims

1. Computer implemented method for simulating the positioning of a sealing gasket (10) on a flange (20),
- said flange (20) has a geometry defined by two curves; and
- said gasket (10) is defined by a 3D finite element model;
**characterised in that** the method is carried out by means of finite elements calculation and comprises the following stages:
- determining a set {P₀, P₁, ..., Pₚ} of pairs of points on said two curves defining the geometry of the flange, said determination comprising:
• defining an auxiliary curve which is the bisector of said two curves,
• determining p points uniformly distributed on said auxiliary curve,
• orthogonally projecting said p points on said two curves,
• said projections forming the set of pairs of points {P₀, P₁, ..., Pₚ};
- determining a set {N₀, N₁, ..., Nₙ} of pairs of nodes of the 3D finite element model defining the sealing gasket with n ≤ p;
- initially positioning the pair of nodes N₀ on the pair of points P₀;
- performing j iterations, with j ≤ n, where j displacements are applied simultaneously in each iteration j in order to position the pair of nodes N₀ on the pair of points Pⱼ, the pair of nodes N₁ on the pair of points Pⱼ₋₁, ..., the pair of nodes Nⱼ on the pair of points P₀, and n - j displacements to position all the remaining pairs of nodes Nᵢ on the position of the pair of nodes Nᵢ₋₁, for i > j.

2. A computer implemented method according to claim 1, **characterised in that** three curves are used in order to define the geometry of the flange, the flange path being unequivocally defined.

## Patentansprüche

1. Computer-implementiertes Verfahren für die Simulation der Positionierung einer Abdichtungsmanschette (10) an einem Flansch (20),
- wobei der genannte Flansch (20) eine durch zwei Kurven definierte Geometrie aufweist; und
- wobei die, genannte Manschette (10) durch ein 3D Finite-Elemente-Modell definiert wird;
**dadurch gekennzeichnet, dass** das Verfahren mittels Finite-Elemente-Berechnung ausgeführt wird und folgende Schritte umfasst:
- Bestimmen eines Satzes {P₀, P₁, ... Pₚ} von. Punktpaaren auf den genannten zwei Kurven, welche die Geometrie des Flansches definieren, wobei die genannte Bestimmung Folgendes umfasst:
• Definieren einer Hilfskurve, die die Winkelhalbierende der genannten zwei Kurven ist,
• Bestimmen von p Punkten, welche gleichmäßig auf der genannten Hilfskurve verteilt sind,
• orthogonales Projizieren der genannten p Punkten auf die genannten zwei Kurven,
• wobei die genannten Projektionen den Satz von Punktpaaren {P₀, P₁, ... Pₚ} bilden;
- Bestimmen eines Satzes {N₀, N₁, ... Nₚ} von Knotenpaaren des 3D Finite-Elemente-Modells, welcher die Abdichtungsmanschette mit n ≤ p definiert;
- anfängliches Positionieren des Paares von Knoten N₀ auf das Paar von Punkten P₀;
- Durchführen von j Iterationen, mit j ≤ n, wobei j Verschiebungen gleichzeitig mit jeder Iteration j angewendet werden, um das Paar von Knoten N₀ auf das Paar von Punkten Pⱼ, das Paar von Knoten N₁ auf das Paar von Punkten Pⱼ₋₁, ..., das Paar von Knoten Nⱼ auf das Paar von Punkten P₀ zu positionieren, und n-j Verschiebungen angewendet werden, um all die restlichen Paaren von Knoten Nᵢ auf die Position des Paares von Knoten Nᵢ₋₁, für i > j zu positionieren.

2. Computer-implementiertes Verfahren nach Anspruch 1, **dadurch gekennzeichnet, dass** drei Kurven verwendet werden, um die Geometrie des Flansches zu definieren, wobei der Flanschverlauf eindeutig definiert wird.

## Revendications

1. Procédé mis en oeuvre par ordinateur pour simuler le positionnement d'un joint d'étanchéité (10) sur un rebord (20),
- ledit rebord (20) ayant une géométrie définie par deux courbes ; et
- ledit joint (10) étant défini par un modèle d'éléments finis tridimensionnel ; **caractérisé en ce que** le procédé est réalisé par le biais de calcul d'éléments finis et comprend les étapes suivantes :
- déterminer un ensemble {P₀, P₁, ..., Pₚ} de paires de points sur lesdites deux courbes définissant la géométrie du rebord, ladite détermination comprenant :
• définir une courbe auxiliaire qui est la bissectrice desdites deux courbes,
• déterminer p points distribués uniformément sur ladite courbe auxiliaire,
• projeter orthogonalement lesdits p points sur lesdites deux courbes,
• lesdites projections formant l'ensemble des paires de points {P₀, P₁, ..., Pₚ} ;
- déterminer un ensemble de {N₀, N₁, ..., Nₙ} de paires de noeuds du modèle d'élément finis 3D définissant le joint d'étanchéité avec n ≤ p ;
- positionner initialement la paire de noeuds N₀ sur la paire de points P₀ ;
- réaliser j itérations, avec j ≤ n, où j déplacements sont appliqués simultanément lors de chaque itération j afin de positionner la paire de noeuds N₀ sur la paire de points Pⱼ, la paire de noeuds N₁ sur la paire de points Pⱼ₋₁, ... la paire de noeuds Nⱼ sur la paire de points P₀, et n-j déplacements pour positionner tout le reste des paires de noeuds Nᵢ sur la position de la paire de noeuds Nᵢ₋₁, pour i > j.

2. Procédé mis en oeuvre par ordinateur selon la revendication 1, **caractérisé en ce que** trois courbes sont utilisées afin de définir la géométrie du rebord, la trajectoire du rebord étant définie de manière univoque.
